# EUROPEAN PATENT APPLICATION

(11) **EP 4 768 935 A1**
(43) Date of publication of application: **01.07.2026**
(21) Application number: 25223420.8
(22) Date of filing: 15.12.2025
(51) Int. Cl.: G01R 31/367, G01R 31/392

(54) **BATTERY DIAGNOSIS DEVICE, METHOD FOR DIAGNOSING A BATTERY AND VEHICLE INCLUDING THE BATTERY DIAGNOSIS DEVICE**

(30) Priority: 27.12.2024 KR 20240199051
(71) Applicant: SAMSUNG SDI CO., LTD., Yongin-si, Gyeonggi-do 17084 (KR)
(72) Inventor: Kim, Eunseon, 17084 Yongin-si, Gyeonggi-do (KR); Jung, Kibong, 17084 Yongin-si, Gyeonggi-do (KR)
(74) Representative: Meissner Bolte Partnerschaft mbB

(57) **Abstract**

A battery diagnosis device (20) may include a database (270) configured to store design data (271) during design process for a battery (10), process data (272) collected during a process of manufacturing the battery (10), evaluation data (273) collected during a process of evaluating the battery (10), and field data (274) collected during a field process with the battery (10). A data link unit (260) is configured to link the design data (271), the process data (272), the evaluation data (273), and the field data (274). A processor (220) configured to, by executing an algorithm stored in a memory (230), (i) extract features based on each of the design data (271), the process data (272), the evaluation data (273), and the field data (274) in the order of the field data (274), the evaluation data (273), the process data (272), and the design data (271), and (ii) generate battery status information including information about the cause of deterioration of the battery (10) and the timing of deterioration of the battery (10) based on the extracted features.

## Description

This application claims priority to and the benefit of Korean Patent Application No. 10-2024-0199051 filed with the Korean Intellectual Property Office on December 27, 2024, the entire contents of which are incorporated herein by reference.

The present invention relates to a method for diagnosing a battery, a battery diagnosis device, and a vehicle including the battery diagnosis device.

Electric vehicles and hybrid electric vehicles are equipped with high-voltage batteries to store electric energy to provide driving power to the vehicles. A vehicle's driving range, maximum motor output, etc. are greatly affected by the capacity and condition of the high-voltage battery it is equipped with.

However, deterioration of a continuously used battery is inevitable. Therefore, diagnosing the life and condition of the battery is important for the performance, reliability, and safety of electric vehicles. Accordingly, a method of predicting the life of a battery by using charge and discharge evaluation data, etc. to detect battery deterioration is generally applied.

However, the causes of battery deterioration are diverse, and it is sometimes necessary to detect the exact cause and degree of battery deterioration using only charge and discharge evaluation data. Accordingly, a method is required to detect battery deterioration by linking each data that may be acquired throughout the entire cycle of the battery, encompassing design, evaluation, process, and field of the battery.

The information disclosed in this background section is to improve understanding of the present invention and may include information that does not constitute prior art.

The present invention relates to a method for diagnosing battery, a battery diagnosis device, and a vehicle including the battery diagnosis device, which may detect the cause and timing of battery deterioration, and may predict whether deterioration has occurred and the performance of the battery according to the deterioration, based on data that may affect battery deterioration in a series of cycles for the battery, encompassing a design stage, a process stage, an evaluation stage, and a field stage of the battery.

However, the technical problems to be solved by the present invention are not limited to the problems described above, and other problems not described herein will be clearly understood by those skilled in the art from the description below.

According to an embodiment of the present invention, a battery diagnosis device may include a database configured to store design data during a process of designing a battery, process data collected during a process of manufacturing the battery, data collected during a process of evaluating the battery, and field data collected during a field process with the battery, a data link unit configured to link the design data, the process data, the evaluation data, and the field data, and a processor configured to, by executing an algorithm stored in a memory, (i) extract features based on each of the design data, the process data, the evaluation data, and the field data in the order of the field data, the evaluation data, the process data, and the design data and (ii) generate battery status information including information about a cause of deterioration of the battery and a timing of deterioration of the battery based on the extracted features.

The processor may determine whether deterioration of the battery has occurred based on the features extracted from the field data, determine whether deterioration of the battery has occurred based on the features extracted from the evaluation data if deterioration of the battery is detected based on the features extracted from the field data, and determine that the cause of the deterioration is at least one of the features extracted based on the field data, and the timing of the deterioration is the time of actual use of the battery if deterioration of the battery is not detected based on the features extracted from the evaluation data.

The processor may determine whether deterioration of the battery has occurred based on the features extracted from the process data if deterioration of the battery is detected based on the features extracted from the evaluation data, and determine that the cause of the deterioration is at least one of the features extracted based on the evaluation data, and the timing of the deterioration is the evaluation time of the battery if deterioration of the battery is not detected based on the features extracted from the process data.

The processor may determine whether deterioration of the battery has occurred based on the features extracted from the design data if deterioration of the battery is detected based on the features extracted from the process data, and determine that the cause of the deterioration is at least one of the features extracted based on the process data, and the timing of the deterioration is the process time of the battery if deterioration of the battery is not detected based on the features extracted from the design data.

The processor may determine that the cause of the deterioration is at least one of the features extracted based on the design data, and the timing of the deterioration is the design time of the battery if deterioration of the battery is detected based on the features extracted from the design data.

The database may store the features extracted based on each of the design data, the process data, the evaluation data, and the field data, and the status information as analysis data, and the processor may predict whether deterioration of the battery has occurred based on the analysis data.

The data link unit may link the design data, the process data, the evaluation data, and the field data based on a link key index uniquely assigned to each product unit.

According to an embodiment of the present invention, a method for diagnosing battery may include a step of collecting design data during a process of designing a battery, collecting during a process of manufacturing the battery, collecting evaluation data during a process of evaluating the battery, and collecting field data during a field process with the battery, a step of linking the design data, the process data, the evaluation data, and the field data, a step of extracting features based on each of the design data, the process data, the evaluation data, and the field data in the order of the field data, the evaluation data, the process data, and the design data, and a step of generating battery status information including information about the cause of deterioration of the battery and the timing of deterioration of the battery based on the extracted features.

The step of generating the battery status information may include a step of determining whether deterioration of the battery has occurred based on the features extracted from the field data, a step of determining whether deterioration of the battery has occurred based on the features extracted from the evaluation data if deterioration of the battery is detected based on the features extracted from the field data, and a step of determining that the cause of the deterioration is at least one of the features extracted based on the field data, and the timing of the deterioration is the time of actual use of the battery if deterioration of the battery is not detected based on the features extracted from the evaluation data.

The step of generating the battery status information may include a step of determining whether deterioration of the battery has occurred based on the features extracted from the process data if deterioration of the battery is detected based on the features extracted from the evaluation data, and a step of determining that the cause of the deterioration is at least one of the features extracted based on the evaluation data and the timing of the deterioration is the evaluation time of the battery if deterioration of the battery is not detected based on the features extracted from the process data.

The step of generating the battery status information may include a step of determining whether deterioration of the battery has occurred based on the features extracted from the design data if deterioration of the battery is detected based on the features extracted from the process data, and a step of determining that the cause of the deterioration is at least one of the features extracted based on the process data and the timing of the deterioration is the process time of the battery if deterioration of the battery is not detected based on the features extracted from the design data.

The step of generating the battery status information may include a step of determining that the cause of the deterioration is at least one of the features extracted based on the design data, and the timing of the deterioration is the design time of the battery if deterioration of the battery is detected based on the features extracted from the design data.

The method for diagnosing battery may further include a step of storing the features extracted based on each of the design data, the process data, the evaluation data, and the field data, and the status information as analysis data, and a step of predicting whether deterioration of the battery has occurred based on the analysis data.

The step of linking the design data, the process data, the evaluation data, and the field data may be performed based on a link key index uniquely assigned to each product unit.

According to an embodiment of the present invention, a vehicle may include a battery pack configured to provide power, a battery management system including a database configured to store design data collected during a process of designing the battery pack, process data collected during a process of manufacturing the battery pack, evaluation data collected during a process of an evaluating the battery pack, and collecting field data during a field process with the battery pack, a data link unit configured to link the design data, the process data, the evaluation data, and the field data, and a processor configured to extract features based on each of the design data, the process data, the evaluation data, and the field data in the order of the field data, the evaluation data, the process data, and the design data, and generate battery status information including information about the cause of deterioration of the battery and the timing of deterioration of the battery based on the extracted features, by executing an algorithm stored in a memory, and an electronic control unit configured to control the vehicle based on the battery status information.

According to the present invention, it is possible to accurately analyze the cause of battery deterioration and the timing of deterioration.

According to the present invention, it is possible to predict an occurrence of battery deterioration and the resulting performance of the battery.

However, the effects obtainable through the present invention are not limited to the effects described above, and other technical effects not mentioned will be clearly understood by those skilled in the art from the description below.

The drawings illustrate preferred embodiments of the present invention and, together with the detailed description below, serve to further describe the technical ideas of the present invention. The present invention should not be interpreted as being limited to matters described in such drawings.
FIG. 1 is a block diagram of a battery diagnosis system according to an embodiment of the present invention.
FIG. 2 is a drawing for explaining operation of a battery diagnosis device according to an embodiment of the present invention.
FIG. 3 is a drawing for explaining operation of a battery diagnosis device according to an embodiment of the present invention.
FIG. 4 is a drawing for explaining the operation of a battery diagnosis device according to an embodiment of the present invention.
FIG. 5 is a flowchart of a method for diagnosing battery according to an embodiment of the present invention.
FIG. 6 is a flowchart of a method for diagnosing battery according to an embodiment of the present invention.
FIG. 7 is a drawing of a vehicle according to an embodiment of the present invention.
FIG. 8 is a drawing of a vehicle according to an embodiment of the present invention.

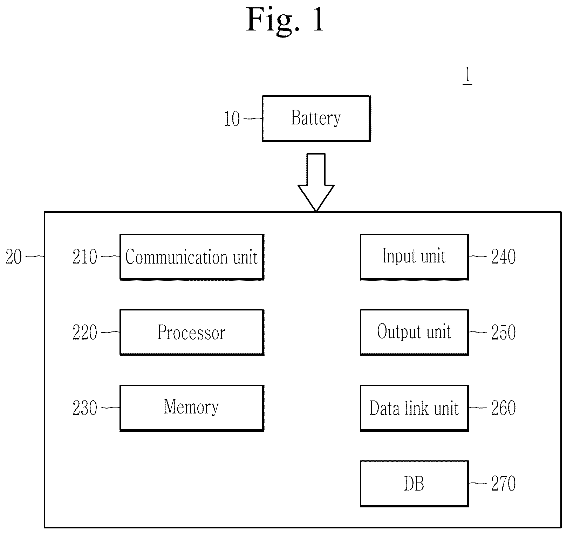

FIG. 1 is a block diagram of a battery diagnosis system according to an embodiment of the present invention.

Referring to FIG. 1, a battery diagnosis system 1 may include a battery 10 and a battery diagnosis device 20. The battery diagnosis device 20 may include a communication unit 210, a processor 220, a memory 230, an input unit 240, an output unit 250, a data link unit 260, and a database (DB) 270.

Various data generated in relation to the design process, manufacturing process, an evaluation process, and a field process of the battery 10 may be input into the battery diagnosis device 20. Based on this data, the battery diagnosis device 20 may generate status information of the battery 10 and predict deterioration of the battery 10.

The communication unit 210 may include a wired or wireless communication module. For example, the communication unit 210 may include modules such as WIFI, short-range wireless communication, ETHERNET, and BLUETOOTH. In some embodiments, the communication unit 210 may include input/output ports that connect to other devices via cables. The communication unit 210 may receive data regarding the battery 10.

In some embodiments, when the database 270 is connected via a network, the communication unit 210 may communicate with the database 270 to receive data regarding the battery 10 required by the processor 220. Additionally, the communication unit 210 may transmit data generated from the processor 220 to the database 270. In some embodiments, the communication unit 210 may transmit status information generated by the battery diagnosis device 20 to a designated terminal or an external server.

The processor 220 may extract information about features that may cause deterioration of the battery 10 based on data about the battery 10 stored in the database 270. The processor 220 may analyze the cause and time of deterioration of the battery 10 based on the extracted features.

In some embodiments, the processor 220 may predict whether deterioration of the battery 10 has occurred based on data stored in the database 270. And the processor 220 may predict the performance of the battery 10 accordingly.

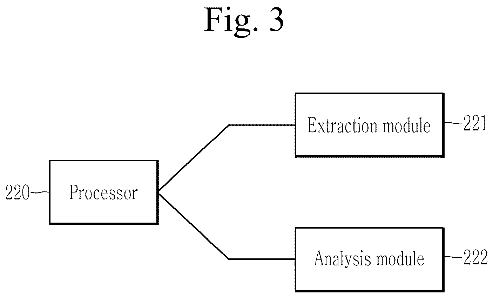

The processor 220 may execute software stored in the memory 230. In some embodiments, the processor 220 may execute an algorithm, such as a machine learning model, stored in memory 230. The processor 220 may extract features that may be the cause of deterioration as described above by executing a machine learning model stored in the memory 230, analyze the cause and timing of deterioration of the battery 10, and perform an operation to predict whether deterioration has occurred and the performance of the corresponding battery 10. Specific details in this regard are described below with reference to Fig. 3.

The processor 220 may generate status information including information on the cause of deterioration of the battery 10, the timing of deterioration, predictions as to whether deterioration has occurred, and performance by the above-described operation. The processor 220 may output status information about the battery 10 through the output unit 250. In some embodiments, the processor 220 may transmit status information about the battery 10 to a designated terminal or external server via the communication unit 210. The processor 220 also may update data stored in the database 270 using the extracted features, analysis results based on the extracted features, and status information.

The memory 230 may store software for executing algorithms for the processor 220 to perform operations as described above. In some embodiments, the memory 230 may temporarily store data generated during the above-described operations of the processor 220.

The memory 230 may be implemented as a non-volatile memory device that maintains stored information even when power is not supplied, such as a flash memory, or a volatile memory device that requires power to maintain stored information, such as a Dynamic Random Access Memory. However, embodiments of the present invention are not necessarily limited to these examples, and the memory 230 may be implemented as various types of memory devices.

The input unit 240 may receive input regarding the operation mode for diagnosing the battery 10. For example, the input unit 240 may receive user commands regarding the start and end of an operation for diagnosing the battery 10. The input unit 240 may be, for example, a button, a switch, a touchpad, etc., but embodiments of the present invention are not limited thereto, and the input unit 240 may be implemented as various types of devices. The input unit 240 may transmit a received user command to the processor 220, thereby causing the processor 220 to perform or terminate a diagnostic operation regarding the battery 10.

The output unit 250 may output the results of the battery diagnosis device 20. The output unit 250 may output status information about the battery 10 according to the control command of the processor 220.

In some embodiments, the status information of the battery 10 may include information regarding the cause of the deterioration and the time that the battery 10 deteriorates. The status information of the battery 10 may include, for example, whether the battery 10 has not yet deteriorated, a prediction result of whether deterioration has occurred in the battery 10, and information on the performance of the battery 10.

The output unit 250 may further output recommended specification information along with status information regarding the battery 10. Recommended specification information may be information indicating the appropriate specifications of a battery 10 to prevent deterioration from occurring, for example, in the event that a particular battery 10 deteriorates. The output unit 250 may output status information and recommended specification information regarding the battery 10 in a report format. The output status information and recommended specification information may be stored in a database 270.

The output unit 250 may be implemented as a speaker, a lamp, a display, etc. For example, the output unit 250 may output sound effects or voice guidance through a speaker, control the turning on, off, and flashing of a lamp, and/or cause the display on a screen at least one of letters, numbers, images, special characters, and emoticons. However, embodiments are not limited thereto, and the output unit 250 may be implemented through various types of devices.

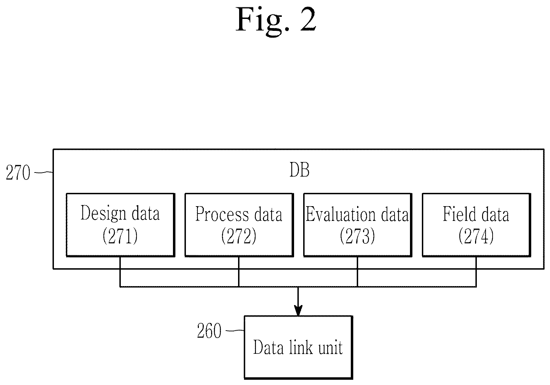

The data link unit 260 may link multiple data stored in the database 270. Specifically, the data link unit 260 may link multiple data stored in the database 270 by product unit based on a linking key index, and the data link unit 260 may manage multiple data stored in the database 270. Specific details in this regard are described below with reference to Fig. 2.

The database 270 may contain a plurality of data. More specifically, the database 270 may store various data derived from the entire cycle encompassing the design process and/or field process of a specific battery 10. Based on the data stored in the database 270, the battery diagnosis device 20 may diagnose whether deterioration has occurred in the battery 10. Specific details in this regard are described below with respect to Fig. 2.

FIG. 2 is a drawing for explaining the operation of a battery diagnosis device 20 according to an embodiment of the present invention.

Referring to FIG. 2, the database 270 may store a plurality of different types of data 271 to 274. Specifically, the database 270 may include design data 271, process data 272, evaluation data 273, and field data 274.

The design data 271 may include data derived from a design process for a specific battery 10 in FIG. 1, such as cell design data including an electrode area,. The process data 272 may include data derived from a process for the battery 10, such as material properties of the battery 10. The evaluation data 273 may include data derived from an evaluation process for the battery 10, such as, for example, a quality inspection result of the battery 10, and the field data 274 may include data derived from an actual use process of the battery 10.

The data link unit 260 may link design data 271, process data 272, evaluation data 273, and field data 274 stored in the database 270. The data link unit 260 may link design data 271, process data 272, evaluation data 273, and field data 274 stored in the database 270 to each other based on a link key index. The link key index may be uniquely assigned to each battery 10. For example, if there is a first type of battery 10 and a second type of battery 10 that is different from the first type of battery 10, the link key index assigned to the first type of battery 10 and the link key index assigned to the second type of battery 10 may be different from each other.

The data link unit 260 may optimize the management of multiple data 271 to 274 stored in the database 270 based on the link key index assigned to each type of battery 10. The data linking unit 260 may efficiently manage by linking the data that may be obtained throughout the entire cycle for each type of battery 10.

FIG. 3 is a drawing for explaining the operation of a battery diagnosis device 20 according to an embodiment of the present invention.

Referring to FIG. 3, the processor 220 may execute an algorithm stored in the memory 230 (i.e., software) as described with reference to FIG. 1. When the algorithm is executed, the processor 220 may extract features and analyze the extracted features to output status information about the battery 10.

That is, the operations of each of the extraction module 221 and the analysis module 222 may be performed by executing the software algorithm by the processor 220. The operations or functions performed by each of the extraction module 221 and the analysis module 222 when the extraction module 221 and the analysis module 222 are executed by the processor 220 are described below.

The extraction module 221 may extract features that indicate the cause of deterioration of the battery 10 based on data provided from the database 270. The extraction module 221 may extract features in a predetermined order. For example, the extraction module 221 may extract features in the order of field data 274, evaluation data 273, process data 272, and design data 271.

The analysis module 222 may analyze the cause and time of deterioration of the battery 10 based on the features extracted from the extraction module 221. The analysis module 222 may generate status information that includes the cause of deterioration and the time of deterioration.

The analysis module 222 may analyze the cause and time of deterioration of the battery 10 based on features extracted in the predetermined order from the extraction module 221. That is, the analysis module 222 may analyze the cause of deterioration and the timing of deterioration in an order corresponding to the order of feature extraction of the extraction module 221.

As a specific example, the extraction module 221 may first extract features based on the field data 274, and the analysis module 222 may analyze the cause of deterioration and the time of deterioration based on the features extracted from the field data 274. Then, the extraction module 221 may extract features based on the evaluation data 273, and the analysis module 222 may analyze the cause of deterioration and the time of deterioration based on the features extracted from the evaluation data 273. Subsequently, the extraction module 221 may extract features based on the process data 272, and the analysis module 222 may analyze the cause of deterioration and the time of deterioration based on the features extracted from the process data 272. Finally, the extraction module 221 may extract features based on the design data 271, and the analysis module 222 may analyze the cause of deterioration and the time of deterioration based on the features extracted from the design data 271.

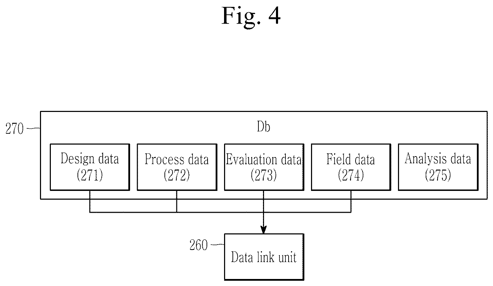

FIG. 4 is a drawing for explaining the operation of a battery diagnosis device 20 according to an embodiment of the present invention. Below, the differences in the embodiment depicted in FIG. 4 and the embodiment depicted in Fig. 2 will be explained.

Referring to FIG. 4, the database 270 may further store analysis data 275. The analysis data 275 may include features extracted by the extraction module 221 based on the design data 271, the process data 272, the evaluation data 273, and the field data 274 (as described with reference to FIG. 3), and status information of the battery 10 regarding the cause of deterioration and the timing of deterioration detected by the analysis module 222.

In some embodiments, the battery diagnosis device 20 may predict the possibility of occurrence of deterioration or whether deterioration will occur for a specific battery 10 based on analysis data 275 stored in the database 270. And the battery diagnosis device 20 may predict the performance of the corresponding battery 10. For example, if design data 271, process data 272, evaluation data 273, and field data 274 for the first battery 10 are stored in the database 270, features of the first battery 10 extracted from the extraction module 221 based on these and status information on the cause of deterioration and the time of deterioration of the first battery 10 detected by the analysis module 222 may be stored in the database 270 as analysis data 275.

When a battery diagnosis operation is performed on a second battery 10 that is different from the first battery 10, the analysis module 222 may predict whether deterioration will occur in the second battery 10 and the performance of the second battery 10 when deterioration occurs based on a plurality of data 271 to 275 for the first battery 10. That is, a battery diagnosis device may efficiently manage by linking each data that may be acquired from the entire cycle of a specific battery 10, and may identify the cause and timing of deterioration through features extracted based on each data. The battery diagnosis device may also predict whether deterioration has occurred in another battery 10 based on the diagnostic result of the specific battery 10 and predict performance accordingly.

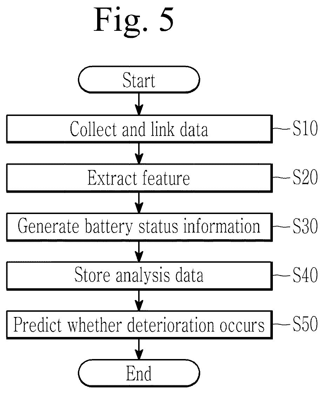

FIG. 5 is a flowchart of a method for diagnosing battery according to an embodiment of the present invention.

Referring to FIG. 5, a method for diagnosing a battery S1 may include a step of collecting and linking data S10. For example, as described above with reference to FIGS. 1 to 4, design data 271, process data 272, evaluation data 273, and field data 274 regarding a battery 10 may be stored in a database 270, and a data link unit 260 may link and manage the plurality of data 271 to 274 based on a linking key index.

The method for diagnosing a battery S1 may include a step of extracting features S20. For example, as described with reference to FIGS. 1 to 4, when an algorithm stored in a memory 230 (i.e., software) is executed by a processor 220, the extraction module 221 may extract features that may be the cause of deterioration based on the above-described plurality of data 271 to 274 stored in a database 270.

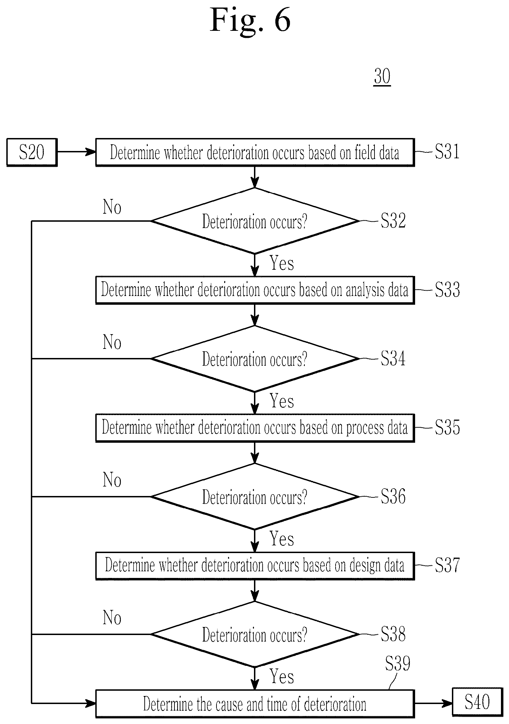

The method for diagnosing a battery S1 may include a step S30 of generating battery status information. For example, as described with reference to FIGS. 1 to 4, when an algorithm (e.g., described by software) stored in the memory 230 is executed by the processor 220, the analysis module 222 may generate status information about the battery 10 based on features extracted from the extraction module 221. The step of generating battery status information S30 is described in more detail below with reference to FIG. 6.

The method for diagnosing battery S1 may include a step of storing analysis data S40. For example, features extracted from the extraction module 221 and status information generated from the analysis module 222 may be stored in the database 270 as analysis data 275.

The method for diagnosing battery S1 may include a step S50 of predicting whether deterioration has occurred. For example, , based on a plurality of data 271 to 274 regarding a specific battery 10 and the extracted features and analysis data 275 based thereon, the analysis module 222 may predict whether deterioration will occur for another battery 10 and accordingly predict the performance of the corresponding battery 10.

FIG. 6 is a flowchart of a method for diagnosing battery according to one embodiment of the present invention.

Referring to FIG. 6, the step of generating battery status information S30 may include a step of determining whether deterioration has occurred based on field data S31. For example,, the analysis module 222 may determine whether there is deterioration based on features extracted in an order from the extraction module 221. That is, the analysis module 222 may first determine whether there is deterioration based on features extracted based on field data 274.

If it is determined that no deterioration of the battery 10 has occurred based on field data 274, (NO of S32), the step of generating battery status information S30 may proceed to the step of determining the cause and time of deterioration S39, and the analysis module 222 may determine that no deterioration of the battery 10 has occurred in step S39.

If it is determined that deterioration of the battery 10 has occurred based on field data 274 (YES of S32), the step of generating battery status information S30 may proceed to the step of determining whether deterioration has occurred based on evaluation data S33. The analysis module 222 may then determine whether there is deterioration based on features extracted based on evaluation data 273.

If it is determined that no deterioration of the battery 10 has occurred based on the evaluation data 273 (NO of S34) the step of generating battery status information S30 may proceed to the step of determining the cause and time of deterioration S39, and the analysis module 222 may determine in step S39 that the deterioration of the battery 10 is caused by field data 274 and occurred during actual use of the battery 10.

If it is determined that deterioration of the battery 10 has occurred based on the evaluation data 273 (YES of S34), the step of generating battery status information S30 may proceed to the step of determining whether deterioration has occurred based on the process data S35. The analysis module 222 may the determine whether there is deterioration based on features extracted based on process data 272.

If it is determined that no deterioration of the battery 10 has occurred based on the process data 272 (NO of S36), the step of generating battery status information S30 may proceed to the step of determining the cause and time of deterioration S39. The analysis module 222 may then determine in step S39 that the deterioration of the battery 10 is caused by the evaluation data 273 and occurred during the evaluation process of the battery 10.

If it is determined that deterioration of the battery 10 has occurred based on process data 272 (YES of S36), the step of generating battery status information S30 may proceed to the step of determining whether deterioration has occurred based on design data S37. The analysis module 222 may then determine whether there is deterioration based on features extracted subsequently based on design data 271.

If it is determined that no deterioration of the battery 10 has occurred based on the design data 271 (NO of S38), the step of generating battery status information S30 may proceed to the step of determining the cause and time of deterioration S39. The analysis module 222 may then determine in step S39 that the deterioration of the battery 10 is caused by the process data 272 and occurred during the process of the battery 10.

If it is determined that deterioration of the battery 10 has occurred based on design data 271 (YES of S38), the step of generating battery status information S30 may proceed to the step of determining the cause and time of deterioration S39. The analysis module 222 may then determine in step S39 that the deterioration of the battery 10 is caused by the design data 271 and occurred during the design process of the battery 10.

The battery diagnosis method according to embodiments of the present invention may efficiently manage data for the entire cycle of the battery 10 by linking data in a series of cycles of the battery 10, i.e., design, process, evaluation, and field, in a dependent relationship. In addition, by determining whether deterioration has occurred based on data from each process in a predetermined order, the cause and time of deterioration of the battery 10 may be accurately identified.

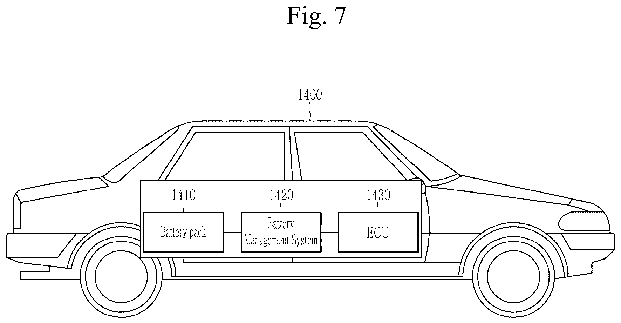

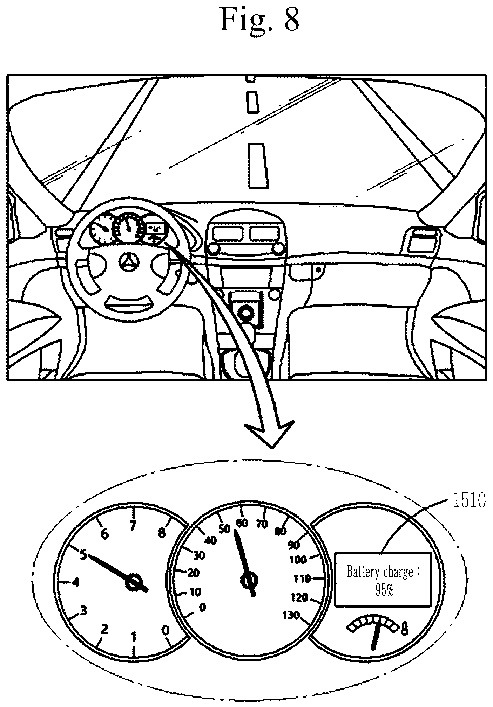

FIGS. 7 and 8 are drawings of a vehicle according to one embodiment of the present invention.

Referring to FIGS. 7 and 8, the vehicle 1400 may include a battery pack 1410 and a battery management system 1420. The vehicle 1400 may use a battery pack 1410 as a power source. The vehicle 1400 may be, for example, an electric vehicle or a hybrid vehicle, but embodiments of the present invention are not limited to these examples.

The battery pack 1410 may include a plurality of battery modules. The battery module may have substantially the same configuration as the battery 10 illustrated in FIG. 1. A battery module may include a plurality of battery cells. The battery management system 1420 may monitor whether an abnormality has occurred in the battery pack 1410.

In embodiments, the battery management system 1420 may include a battery diagnosis device 20 as described with reference to FIGS. 1 through 6. The battery management system 1420 may determine the degree of deterioration of each battery cell included in the battery pack 1410 through such a battery diagnosis device 20.

Specifically, the battery management system 1420 may efficiently manage data on the battery pack 1410 by linking data derived from a series of cycles, i.e., design, process, evaluation, and field, in a dependent relationship for the battery pack 1410. And the battery management system 1420 may accurately identify the cause and time of deterioration of the battery pack 1410 by determining whether deterioration has occurred based on data from each process in a predetermined order for the battery pack 1410. Specific operations related to this are described above with reference to FIGS. 1 to 6.

The battery management system 1420 may transmit status information of the battery pack 1410 to the electronic control unit (ECU) 1430 of the vehicle 1400. The ECU 1430 of the vehicle 1400 may control the vehicle 1400 based on the status information of the battery pack 1410. In some embodiments, the ECU 1430 may output status information to a display of the vehicle 1400. For example, as illustrated in FIG. 8, the ECU 1430 may display status information of the battery pack 1410 on the instrument panel 1510 in the vehicle 1400. In some embodiments, the ECU 1430 may display the remaining driving distance, etc. determined based on the status information on the instrument panel 1510. Additionally, although not shown in FIG. 8, the ECU 1430 may display on the instrument panel 1510 an indication that the battery pack 1410 is deteriorating based on status information of the battery pack 1410.

Although the present invention has been described above by means of limited embodiments and drawings, the present invention is not limited to the described embodiments. Various modifications and variations are possible within the scope of the technical idea of the present invention by a person skilled in the art to which the present invention pertains.

## Claims

1. A battery diagnosis device (20) comprising:
a database (270) configured to store design data (271) during a process of designing a battery (10), process data (272) collected during a process of manufacturing the battery (10), evaluation data (273) collected during a process of evaluating the battery (10), and field data (274) collected during a field process with the battery (10);
a data link unit (260) configured to link the design data (271), the process data (272), the evaluation data (273), and the field data (274); and
a processor (220) configured to, by executing an algorithm stored in a memory (230), (i) extract features based on each of the design data (271), the process data (272), the evaluation data (273), and the field data (274) in the order of the field data (274), the evaluation data (273), the process data (272), and the design data (271) and (ii) generate battery status information including information about a cause of deterioration of the battery (10) and a timing of deterioration of the battery (10) based on the extracted features.

2. The battery diagnosis device (20) of claim 1, wherein the processor (220) is configured to:
determine whether deterioration of the battery (10) has occurred based on the features extracted from the field data (274),
determine whether deterioration of the battery (10) has occurred based on the features extracted from the evaluation data (273) if deterioration of the battery (10) is detected based on the features extracted from the field data (274), and
determine that the cause of the deterioration is at least one of the features extracted based on the field data (274), and the timing of the deterioration is a time of actual use of the battery (10) if deterioration of the battery (10) is not detected based on the features extracted from the evaluation data (273).

3. The battery diagnosis device (20) of claim 2, wherein the processor (220) is configured to:
determine whether deterioration of the battery (10) has occurred based on the features extracted from the process data (272) if deterioration of the battery (10) is detected based on the features extracted from the evaluation data (273), and
determine that the cause of the deterioration is at least one of the features extracted based on the evaluation data (273), and the timing of the deterioration is an evaluation time of the battery (10) if deterioration of the battery (10) is not detected based on the features extracted from the process data (272).

4. The battery diagnosis device (20) of claim 3, wherein the processor (220) is configured to:
determine whether deterioration of the battery (10) has occurred based on the features extracted from the design data (271) if deterioration of the battery (10) is detected based on the features extracted from the process data (272), and
determine that the cause of the deterioration is at least one of the features extracted based on the process data (272), and the timing of the deterioration is a process time of the battery (10) if deterioration of the battery (10) is not detected based on the features extracted from the design data (271).

5. The battery diagnosis device (20) of claim 4, wherein the processor (220) is configured to determine that the cause of the deterioration is at least one of the features extracted based on the design data (271), and the timing of the deterioration is a design time of the battery (10) if deterioration of the battery (10) is detected based on the features extracted from the design data (271).

6. The battery diagnosis device (20) of any one of claims 1 to 5, wherein the database (270) is configured to store the features extracted based on each of the design data (271), the process data (272), the evaluation data (273), and the field data (274), and the status information as analysis data (275), and
wherein the processor (220) is configured to predict whether deterioration of the battery (10) has occurred based on the analysis data (275).

7. The battery diagnosis device (20) of any one of claims 1 to 6, wherein the data link unit (260) is configured to link the design data (271), the process data (272), the evaluation data (273), and the field data (274) based on a link key index uniquely assigned to each product unit.

8. A method for diagnosing a battery (10), the method comprising:
a step of collecting design data (271) during a process of designing a battery (10), collecting process data (272) during a process of manufacturing data, collecting evaluation data (273) during a process of evaluating the battery (10), and collecting field data (274) during field process with the battery (10);
a step of linking the design data (271), the process data (272), the evaluation data (273), and the field data (274);
a step of extracting features based on each of the design data (271), the process data (272), the evaluation data (273), and the field data (274) in the order of the field data (274), the evaluation data (273), the process data (272), and the design data (271); and
a step of generating battery status information including information about a cause of deterioration of the battery (10) and a timing of deterioration of the battery (10) based on the extracted features.

9. The method for diagnosing a battery (10) of claim 8, wherein the step of generating the battery status information includes:
a step of determining whether deterioration of the battery (10) has occurred based on the features extracted from the field data (274);
a step of determining whether deterioration of the battery (10) has occurred based on the features extracted from the evaluation data (273) if deterioration of the battery (10) is detected based on the features extracted from the field data (274); and
a step of determining that the cause of the deterioration is at least one of the features extracted based on the field data (274), and the timing of the deterioration is a time of actual use of the battery (10) if deterioration of the battery (10) is not detected based on the features extracted from the evaluation data (273).

10. The method for diagnosing a battery (10) of claim 9, wherein the step of generating the battery status information includes:
a step of determining whether deterioration of the battery (10) has occurred based on the features extracted from the process data (272) if deterioration of the battery (10) is detected based on the features extracted from the evaluation data (273); and
a step of determining that the cause of the deterioration is at least one of the features extracted based on the evaluation data (273) and a timing of the deterioration is the evaluation time of the battery (10) if deterioration of the battery (10) is not detected based on the features extracted from the process data (272).

11. The method for diagnosing a battery (10) of claim 10, wherein the step of generating the battery status information includes:
a step of determining whether deterioration of the battery (10) has occurred based on the features extracted from the design data (271) if deterioration of the battery (10) is detected based on the features extracted from the process data (272); and
a step of determining that the cause of the deterioration is at least one of the features extracted based on the process data (272) and the timing of the deterioration is a process time of the battery (10) if deterioration of the battery (10) is not detected based on the features extracted from the design data (271).

12. The method for diagnosing a battery (10) of claim 11, wherein the step of generating the battery status information includes a step of determining that the cause of the deterioration is at least one of the features extracted based on the design data (271), and the timing of the deterioration is a design time of the battery (10) if deterioration of the battery (10) is detected based on the features extracted from the design data (271).

13. The method for diagnosing a battery (10) of any one of claims 8 to 12, further comprising:
a step of storing the features extracted based on each of the design data (271), the process data (272), the evaluation data (273), and the field data (274), and the status information as analysis data (275); and
a step of predicting whether deterioration of the battery (10) has occurred based on the analysis data (275).

14. The method for diagnosing a battery (10) of any one of claims 8 to 13, wherein the step of linking the design data (271), the process data (272), the evaluation data (273), and the field data (274) is performed based on a link key index uniquely assigned to each product unit.

15. A vehicle (1400) comprising:
a battery pack (1410) configured to provide power;
a battery management system (1420) including a database (270) configured to store design data (271) during a process of designing the battery pack (1410), process data (272) collecting during a process of manufacturing the battery pack (1410), data collected during a process of evaluating the battery pack (1410), and field data (274) collected during a field process with the battery pack (1410), a data link unit (260) configured to link the design data (271), the process data (272), the evaluation data (273), and the field data (274), and a processor (220) configured to, by executing an algorithm stored in a memory (230), (i) extract features based on each of the design data (271), the process data (272), the evaluation data (273), and the field data (274) in the order of the field data (274), the evaluation data (273), the process data (272), and the design data (271) and (ii) generate battery status information including information about a cause of deterioration of the battery (10) and a timing of deterioration of the battery (10) based on the extracted features; and
an electronic control unit (1430) configured to control the vehicle (1400) based on the battery status information.
